# DEMANDE DE BREVET EUROPEEN

(11) **EP 1 462 539 A1**
(43) Date de publication de la demande: **29.09.2004**
(21) Numéro de dépôt: 04290779.0
(22) Date de dépôt: 23.03.2004
(51) Int. Cl.: C23C 16/02, C22B 5/14, B22F 9/22, C23C 16/442

(54) **Procédés de fabrication de particules métalliques revêtues et d'un matériau composite, et installation pour la mise en oeuvre de tels procédés**

(30) Priorité: 25.03.2003 FR 0303629
(71) Demandeur: Lifco Industrie, 76750 Buchy (FR)
(72) Inventeur: Iacob, Constantin, 76690 Saint Georges sur Fontaine (FR); Bucher, Sébastien, 76000 Rouen (FR)
(74) Mandataire: Bentz, Jean-Paul

(57) **Abrégé**

A partir de grains d'un oxyde ou d'un mélange d'oxydes d'au moins un métal, on réalise une première étape de réduction au moins partielle des grains de l'oxyde métallique au moyen d'un gaz réducteur en lit fluidisé à une température prédéterminée, et une seconde étape de dépôt, dans un lit fluidisé, d'un ou plusieurs corps choisis parmi les métaux et les métalloïdes. Lors de la première étape, on chauffe les grains au moyen d'un chauffage par induction à une fréquence prédéterminée choisie de façon à régler ou à limiter la zone de pénétration des courants induits à l'intérieur des grains.

## Description

La présente invention concerne un procédé de fabrication de particules métalliques revêtues, ainsi qu'un procédé de fabrication d'un matériau composite à partir des dites particules métalliques revêtues.

L'invention vise plus particulièrement la préparation de telles particules métalliques revêtues à partir de grains d'un oxyde d'au moins un métal ou à partir de grains d'un mélange d'oxydes d'au moins un métal.

L'invention se rapporte enfin à une installation adaptée pour la mise en oeuvre des procédés de fabrication mentionnés ci-dessus

A l'heure actuelle, les matériaux composites trouvent une application dans les domaines les plus divers, et notamment en métallurgie, mécanique, électronique, biomédical, dans les emballages, l'aéronautique ou encore dans l'automobile.

Un procédé connu pour fabriquer un matériau composite est celui de la métallurgie des poudres. Ce procédé consiste à compacter puis à fritter une poudre formée de particules plus ou moins finement divisées.

La fabrication industrielle d'un matériau composite est à ce jour principalement réalisée à partir de mélanges de différentes poudres.

Toutefois, on relève un certain nombre d'inconvénients dans la mise en oeuvre de ce procédé industriel. Outre l'hétérogénéité du matériau composite obtenu, la mise en oeuvre s'avère parfois très difficile car elle implique des températures de frittage élevées. Par ailleurs, il y a une certaine limite dans le choix du type de matériaux et bien évidemment le prix de revient est relativement élevé.

Pour remédier à ces inconvénients, on a proposé l'utilisation des poudres formées de particules dites "particules revêtues".

Les principaux avantages de l'utilisation des particules revêtues résident dans la simplification des procédés de fabrication : l'opération de mélange des poudres avec des liants est éliminée, l'étape de compactage est simplifiée, la température de frittage est diminuée.

Grâce à cette technique, la surface des dites particules peut être fonctionnalisée. Ainsi, de nouvelles propriétés, telles que la résistance à l'usure et/ou à la corrosion, l'isolation, la conductivité thermique ou électrique, des propriétés magnétiques, de biocompatibilité,... peuvent être obtenues. De plus, des particules ainsi revêtues peuvent être alliées à un granulé solide.

Cette technologie des particules revêtues est notamment décrite dans le document US 4,746,547. Des particules métalliques (nickel et fer) et d'un oxyde d'aluminium (alumine), de taille inférieure à 100 microns, voire 40 microns, sont revêtues de silicium ou de nickel. L'installation utilisée est un four à lit fluidisé circulant de type "fluidisation par dessous" avec plaque poreuse de fluidisation et un chauffage par résistances électriques.

Toutefois, ce procédé de l'art antérieur ne permet de traiter les particules qu'avec un seul revêtement à la fois. En outre, il est impossible de contrôler l'épaisseur et l'adhérence des revêtements réalisés.

Le document WO 89/12887 décrit un procédé de traitement de particules métalliques de taille inférieure à 1 mm par un gaz mixte constitué de silane et hydrogène, afin de réaliser dans un premier temps un dépôt de silicium, oxydé dans une étape ultérieure en silice. Le traitement a lieu dans un lit fluidisé chauffé par résistances électriques avec une fluidisation "par dessous" à travers une grille.

Ce document WO 89/12887 décrit également un procédé de fabrication de particules métalliques revêtues à partir de grains d'un oxyde ou d'un mélange d'oxydes d'au moins un métal, dans lequel on réalise :
- une première étape de réduction au moins partielle des grains de l'oxyde métallique au moyen d'un gaz réducteur en lit fluidisé à une température prédéterminée, et
- une seconde étape de dépôt, dans un lit fluidisé, d'un ou plusieurs corps choisis parmi les métaux et les métalloïdes.

La première étape permet de réduire l'oxyde métallique et d'obtenir le métal correspondant. Cette étape permet donc la création de porosités au sein de la structure de chacun des grains.

A titre d'exemple, les particules métalliques traitées conformément au procédé décrit dans le document WO 89/12887 sont sous forme de poudres constituées de grains poreux ayant des dimensions comprises entre 0,1 et 1 mm, avec une taille de pores comprise entre 1 et 0,01 µm. De telles dimensions de pores permettent, lors de la deuxième étape, au silane de s'infiltrer à l'intérieur des grains et de se déposer sur les particules individuelles en créant un enrobage de la particule.

Le procédé décrit par le document WO 89/12887 est par ailleurs très avantageux sur le plan industriel puisqu'il permet d'utiliser le même réacteur pour, à la fois, préparer les particules puis les traiter et ce, par simple changement de gaz réactif.

Toutefois, malgré ses nombreux avantages, ce procédé ne permet pas de contrôler, de manière précise, la taille et la distribution des pores au sein des grains réduits obtenus lors de la première étape et, par conséquent, l'épaisseur ainsi que l'homogénéité de la couche du corps déposé lors de la seconde étape.

En outre, les 4 exemples de réalisation cités par le document WO 89/12887 mentionnent l'utilisation de grains de goethite comme produit de départ. Cette goethite, qui est un minerai de fer naturel contenant de l'oxyde ferrique α hydraté (αFeOOH), est transformé en oxyde de fer magnétique Fe₃O₄ ou Fe₂O₃γ conformément à l'enseignement du document FR 2 487 326. On constate donc que le produit de départ nécessite un traitement préalable avant de subir la première étape de réduction, ce qui n'est pas sans incidence sur le coût du procédé dans son ensemble.

La présente invention se rapporte donc à un procédé du type précité, qui comprend une première étape de réduction puis une seconde étape de dépôt, qui permet non seulement de déposer des métaux, métalloïdes mais également des non-métaux et des céramiques, ledit procédé résolvant les problèmes mentionnés ci-dessus.

Selon l'invention, lors de la première étape, on chauffe les grains au moyen d'un chauffage par induction, les grains étant, dans l'hypothèse où ils ne seraient pas magnétiques, préalablement chauffés indirectement par résistances électriques, le chauffage par induction étant effectué à une fréquence prédéterminée choisie de façon à régler ou à limiter la zone de pénétration des courants induits à l'intérieur des grains.

Grâce à l'utilisation d'un chauffage par induction, on contrôle la taille et la distribution des pores dans les grains traités et donc l'épaisseur du ou des corps déposés lors de la deuxième étape.

L'épaisseur des grains dans laquelle des pores seront formés, par réduction de l'oxyde métallique en métal, est ainsi clairement maîtrisée. On peut en particulier envisager de modifier des grains d'oxydes métalliques jusqu'à coeur.

Ainsi, grâce au procédé selon l'invention, et en fonction du ou des corps déposés lors de la deuxième étape, il devient possible de modifier les propriétés surfaciques ou volumiques des grains d'oxydes métalliques, par modification de leur composition chimique et de leur morphologie, en surface ou à coeur.

Dans la suite de la présente demande, on considère que l'expression "particule métallique revêtue" couvre les particules revêtues lors de la deuxième étape de dépôt, qu'elles soient obtenues à partir de grains partiellement réduits ou à partir de grains totalement réduits lors de la première étape du procédé selon l'invention.

On peut notamment obtenir des particules métalliques revêtues présentant de nouvelles propriétés : allègement de la masse des particules, résistance mécanique accrue, notamment à l'usure ou à la corrosion, isolation ou conductivité électrique ou thermique, surfaces fonctionnalisées, propriétés magnétiques, porosité contrôlée, isotropie ou anisotropie, caractère hydrophile ou hydrophobe, biocompatibilité, etc.

A titre d'exemples non limitatifs, on peut notamment revêtir des grains métalliques par un ou plusieurs corps choisis parmi les métaux purs, oxydes, carbures, nitrures,... et obtenir ainsi une grande diversité de particules métalliques revêtues.

Il est important de noter que le procédé selon l'invention permet notamment de fabriquer des particules métalliques revêtues, ou particules composites, à partir d'une matière première à faible coût de revient et/ou qui ne nécessite pas une préparation spécifique. Ceci représente donc un avantage indéniable en termes de coût de revient du procédé selon l'invention.

Parmi les produits de départ que l'on peut utiliser, on peut citer, à titre d'exemple, les fines d'oxydes naturels, ou des mélanges d'oxydes naturels. De tels produits peuvent être non, ou très peu, poreux.

Lorsque les grains de départ comprennent un composant magnétique, le chauffage par induction se suffit à lui seul. Par contre, dans le cas où ces grains ne présentent aucune propriété magnétique, il devient nécessaire d'initialiser le chauffage par induction, en procédant à un chauffage préalable des dits grains au moyen d'un chauffage conventionnel, par exemple au moyen de résistances ohmiques.

En résumé, le procédé selon l'invention permet de fabriquer des particules composites, dont la composition après traitement est clairement maîtrisée, à faible coût de revient assorti d'un très bon rendement, d'une grande facilité de mise en oeuvre et dont le contrôle à l'échelle industrielle est assuré.

Dans une version avantageuse de l'invention, lors de l'étape de dépôt, on chauffe également les grains au moyen d'un chauffage par induction à une fréquence prédéterminée choisie de façon à limiter les réactions chimiques au volume chauffé des grains.

Ainsi, comme lors de la première étape de réduction, le chauffage par induction permet de contrôler l'épaisseur du grain dans lequel le dépôt du ou des corps va se produire.

Ce chauffage par induction lors de la deuxième étape assure en outre un rendement très élevé de cette étape de dépôt.

Dans le cadre de la présente invention, on peut envisager, pour la seconde étape, différents procédés de dépôt, aboutissant chacun à une forme distincte de dépôt.

On peut premièrement utiliser des précurseurs, solides, liquides ou gazeux, qui réagissent en phase gazeuse avec les grains réduits obtenus lors de la première étape.

Un tel traitement permet d'obtenir des couches homogènes du ou des corps localisées au niveau de la surface des grains réduits, et en l'absence de toute diffusion du ou des corps à travers les pores formés dans l'épaisseur des grains.

Pour améliorer l'accrochage de tels dépôts au niveau de la surface des dits grains, l'étape de dépôt peut être précédée par une étape d'activation de la surface des grains réduits, au moyen d'un plasma, par exemple un plasma d'azote en post-décharge non ionique lointaine.

On peut également réaliser la diffusion d'au moins un corps, tel qu'un métalloïde ou un métal, dans les grains réduits obtenus lors la première étape, par dissociation ou décomposition de gaz actifs ou de solides actifs.

Grâce à ce second mode de réalisation, on obtient des particules composites dans lesquelles le ou les corps déposés lors de la seconde étape ont diffusé, à travers les pores formés lors de la première étape, dans l'épaisseur des grains et s'insèrent dans le réseau cristallin dans l'épaisseur réduite des grains.

Cette diffusion se produit avec maintien ou non de la porosité formée lors de la première étape de réduction, en fonction des conditions expérimentales, notamment de la quantité de corps diffusée, du temps de diffusion.

On peut enfin réaliser un lit fluidisé triphasique comprenant une phase solide formée par les grains réduits obtenus lors de la première étape, une phase gazeuse comprenant un gaz de fluidisation inerte et une phase liquide comprenant un mélange de sels métalliques et un réducteur.

Un tel mode de réalisation permet d'obtenir une couche en surface qui est généralement non homogène en épaisseur et parfois poreuse. Une telle couche permet de réaliser ultérieurement des réactions de germination et de croissance suivant des directions privilégiées, ce qui est très intéressant dans le cas de certaines applications.

On peut ainsi envisager la réalisation de particules métalliques revêtues présentant une surface fonctionnalisée, par exemple par un greffage organique.

D'autres propriétés et avantages de la présente invention résulteront de la description qui va suivre, donnée à titre d'exemple non limitatif et faite en référence aux figures suivantes :
- la figure 1 représente, de manière schématique, une installation permettant la mise en oeuvre des procédés selon l'invention ;
- la figure 2 représente de manière schématique la structure morphologique d'une particule composite revêtue conforme à la présente invention.

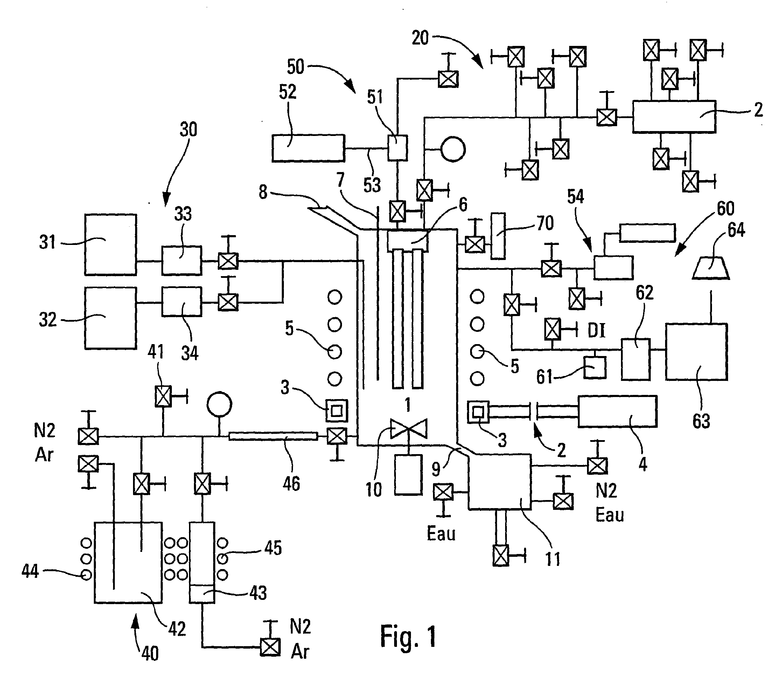

Sur la figure 1, on a schématisé un réacteur de traitement 1 à lit fluidisé, constitué par une enceinte étanche en céramique. De préférence, ce réacteur ne comporte pas de plaque de fluidisation.

Ce réacteur de traitement 1 est équipé d'un dispositif de chauffage par induction 2 qui permet le chauffage superficiel ou à coeur des grains d'oxydes à traiter en augmentant le rendement et le contrôle du dépôt.

Ce dispositif de chauffage par induction 2 est constitué par un inducteur 3 en cuivre refroidi à l'eau et un générateur 4 de très haute fréquence (1 à 3 MHz), de 10 KW par exemple.

En parallèle de ce dispositif de chauffage par induction 2, on peut prévoir des résistances électriques 5 qui permettent de maintenir la température de traitement dans le réacteur de traitement 1 et, dans le cas où les grains d'oxydes n'auraient pas de propriété magnétiques, d'initialiser le chauffage.

Le réacteur de traitement 1 comprend des thermocouples (non représentés) pour mesurer la température à l'intérieur du réacteur 1, ainsi qu'un pH-mètre 7 pour la mesure du pH lors d'un traitement en phase aqueuse. Une armoire électrique de puissance et de régulation assure le bon fonctionnement de l'ensemble.

Le réacteur de traitement 1 comprend en outre, dans sa partie supérieure, un orifice d'entrée 8 permettant l'introduction des grains à traiter et, dans sa partie inférieure, un orifice de sortie 9 pour la récupération des particules métalliques revêtues ainsi qu'un agitateur mécanique 10 pour homogénéiser les grains et éviter toute agglomération de ceux-ci, en particulier à haute température.

Les grains et particules sont respectivement introduits par l'orifice d'entrée 8 et évacués par l'orifice de sortie 9 au moyen de systèmes étanches à vis sans fin.

La fluidisation des grains introduits par l'orifice d'entrée 8 peut être réalisée à l'aide de tuyaux verticaux 6.

L'orifice de sortie 9 est relié à un bac étanche 11 assurant la récupération et le traitement final des particules composites obtenues. Ce bac 11 peut par exemple fonctionner sous azote et permettre le refroidissement et la trempe des dites particules composites. On peut également envisager de sécher les particules, dans un autre lit fluidisé (non représenté) ou par réintroduction dans le réacteur de traitement 1, et de les séparer après refroidissement par tri magnétique.

Le réacteur de traitement 1 peut être relié à l'un ou plusieurs modules, en fonction du procédé de dépôt envisagé lors de la deuxième étape.

La présente figure fait apparaître une installation rassemblant l'ensemble des modules envisageable. Il est cependant tout à fait possible de n'envisager la combinaison du réacteur de traitement 1 qu'avec un seul ou certains seulement des modules que l'on va décrire ci-après.

Le module de gestion des gaz porteurs et/ou actifs 20 est constitué d'un four de dissociation 21 électrique avec une température maximale de 1000 °C par exemple, qui permet une dissociation, complète ou partielle, des gaz actifs. Ce four 20 préchauffe aussi les gaz porteurs.

La pression des gaz est indiquée par un manomètre, les débits par des débitmètres. Des détendeurs permettent le réglage des pressions de travail (2 à 4 bars par exemple).

D'autres gaz actifs prévus sont stockés dans des bouteilles ou sont au contraire produits *in situ.*

Le gaz réducteur de la première étape peut notamment être généré *in situ* à partir, par exemple, du méthane ou de l'ammoniac.

Le module de production des liquides actifs 30 est constitué par des bacs de préparation 31 et des bacs de stockage 32 des produits actifs, tels que sels de métaux à déposer, agents réducteurs et de stabilisation, agents basiques et acides, etc..., mais aussi par des pompes de recirculation 33 et 34 et des vannes.

Le module de production et gestion des précurseurs 40, comporte des récipients de stockage et de vaporisation des précurseurs gazeux 41, liquides 42 et solides 43. Ce module 40 permet la vaporisation des produits actifs et leur déplacement à l'aide de gaz vecteurs, tels que azote, argon et hélium, vers le réacteur de traitement 1 à lit fluidisé. La pression du système est contrôlée par un manomètre. Le débit est réglable par de vannes et indiqué par des débitmètres. Les réacteurs sont chauffés par résistances électriques 44, 45. Une température constante est maintenue sur le trajet de la vapeur jusqu'au réacteur de traitement 1 à lit fluidisé par des moyens classiques schématisés en 46.

Il y a lieu de noter que, pour la vaporisation des précurseurs solides, on procède à leur fluidisation dans un four 43 à lit fluidisé chauffé électriquement par exemple. Ils ne sont donc pas mélangés directement avec les poudres à traiter comme d'autres technologies le prévoient. Ceci évite la vaporisation et la décomposition simultanée du précurseur et la formation de particules de métal pur.

Le module de production et gestion du plasma à post-décharge lointaine et du vide 50 est formé d'une cavité résonante 51 refroidie par air comprimé et reliée à un générateur micro-ondes 52 fonctionnant par exemple à 2450 MHz et délivrant une puissance maximale de 1200 W par exemple. Le tube à décharge 53 est un tube de quartz, par exemple de 70 cm de long et de 9 mm de diamètre. Tout autre système de production du plasma peut être utilisé.

Un groupe à vide primaire 54 permet la réalisation d'un plasma ou d'un vide dans le four à lit fluidisé.

Le module d'évacuation et traitement de gaz 60 comprend un dissociomètre 61 qui permet de déterminer le taux de dissociation des gaz. Ce taux de dissociation est fonction du débit des gaz et de la température de traitement. Il s'agit d'un paramètre particulièrement important dans le cadre de la mise en oeuvre de certaines technologies.

Ce module d'évacuation et traitement de gaz 60 permet le refroidissement des gaz de traitement, son contrôle, la rétention des fines dans le filtre 62 et le traitement des gaz au niveau de la cuve 63 avant sortie dans l'atmosphère par la hôte 64.

Un réfrigérant 70 permet la condensation des vapeurs dans le cas de traitement en lit fluidisé trois phases.

On peut utiliser de façon connue, en cas de besoin, une flamme de veille (non représentée) dans certains traitements.

Le procédé de fabrication de particules métalliques revêtues à partir de grains d'un oxyde ou d'un mélange d'oxydes d'au moins un métal selon l'invention, ainsi qu'un mode de fonctionnement de l'installation représentée sur la figure 1 vont être détaillés ci-après.

La première étape du procédé selon l'invention consiste à réaliser la réduction au moins partielle des grains de l'oxyde métallique au moyen d'un gaz réducteur en lit fluidisé à une température prédéterminée. Lors de cette première étape, on chauffe les grains au moyen du dispositif de chauffage par induction 2. Dans le cas où les grains ne seraient pas magnétiques, ils sont préalablement chauffés indirectement au moyen de résistances électriques 5. Le chauffage par induction est effectué à une fréquence prédéterminée choisie de façon à régler ou à limiter la zone de pénétration des courants induits à l'intérieur des grains.

A titre d'exemple, des grains de fines de minerai de fer, d'une granulométrie comprise entre 1 et 500 µm, et formées d'un mélange d'oxydes non poreux comprenant de l'hématite, de la silice et d'autres oxydes en proportion massique 94/5/1, sont introduits par l'orifice d'entrée 8 dans le réacteur de traitement 1 à l'aide d'un système de chargement, de préférence étanche et à vis sans fin.

Le traitement peut avoir lieu par tranches granulométriques de 50 microns.

Le rôle de la silice, ou éventuellement des autres oxydes non ferreux, est d'empêcher le collage et l'agglomération des grains d'oxydes de fer lors de leur transformation.

La fluidisation en régime hétérogène du mélange d'oxydes est assurée par un gaz porteur préchauffé, tel que l'azote, introduit dans le réacteur de traitement 1 par des tuyaux verticaux 6 à partir du module de gestion 20.

Un gaz actif et réducteur, par exemple de l'ammoniac, est introduit dans le four de dissociation 21 porté à environ 850°C. Dans de telles conditions de température, l'ammoniac se dissocie complètement pour former un mélange d'azote et d'hydrogène.

Le rapport gaz réducteur/gaz porteur est réglable à l'aide de débitmètres. Dans le cas particulier où l'on utilise de l'ammoniac et de l'azote, un rapport ammoniac/azote de l'ordre de 40/60 est avantageux. La pression de ces gaz est réglée à 4 bars.

Le gaz porteur préchauffé et le mélange obtenu par dissociation ci-dessus sont ensuite mélangés, avant introduction dans le réacteur de traitement 1.

La réduction de l'oxyde de fer a lieu par l'action réductrice de l'hydrogène et conduit à la formation de la vapeur d'eau. Cette vapeur d'eau est évacuée du réacteur de traitement 1 par le module d'évacuation et de traitement des gaz 60. Les autres oxydes ne sont pas réduits.

La température du réacteur de traitement 1 à lit fluidisé est inférieure à 750 °C. Le temps d'un cycle de traitement est au minimum de 10 heures pour l'obtention d'un grain réduit traité à coeur, c'est-à-dire un grain de fer pur.

Pour obtenir des grains réduits avec une couche de fer pur en surface et le coeur en oxyde de fer (hématite, magnétite ou wüstite), on modifie la température et le temps de traitement. Le tableau 1 ci-dessous présente les teneurs en fer totales des oxydes réduits en fonction des paramètres de traitement.

**Tableau 1**

| Paramètres Teneur Fe (%) | Température (°C) | Temps (h) | Taux de réduction (%) |
|---|---|---|---|
| 99 | 725 | 8 | 95 |
| 95 | 725 | 6 | 90 |
| 85 | 675 | 4 | 75 |
| 80 | 650 | 2 | 65 |

Le grain plus ou moins réduit obtenu est poreux. Le taux de porosité et la taille des pores sont fonction du temps de traitement, donc du taux de réduction des oxydes de fer. La teneur en carbone du grain de fer poreux est inférieure à 0.001 %.

Le chauffage initial du réacteur de traitement 1 à lit fluidisé est assuré par des résistances électriques 5 en raison d'une plus faible conductivité électrique et perméabilité magnétique du mélange d'oxydes. Au fur et à mesure de l'apparition du fer en surface des granulés, le dispositif de chauffage par induction 2 est activé.

La perte de masse lors du processus de réduction étant considérable, le volume occupé par les grains plus ou moins réduits s'adapte bien à ce type de chauffage par induction. De préférence, le dispositif de chauffage par induction 2 est situé dans la partie inférieure du réacteur de traitement 1. Le choix judicieux de la fréquence du courant induit permet de régler la profondeur de chauffage du grain et donc le volume du grain à traiter.

On réalise ensuite la seconde étape de dépôt, dans le lit fluidisé, pour procéder au dépôt d'un ou plusieurs corps choisis parmi les métaux, les non-métaux, les métalloïdes, les composés de type céramiques tels que les nitrures, les borures, les carbures, les oxydes,....

De façon générale, on peut déposer des corps simples, tels que des métaux, non-métaux, métalloïdes, mais également des corps composés, obtenus par combinaison de corps simples, parmi lesquels on peut notamment citer les céramiques.

Comme on l'a indiqué précédemment, on peut envisager, pour cette seconde étape, différents procédés de dépôt, aboutissant chacun à une forme distincte de particules composites.

### 1^{er} type de dépôt

On peut utiliser des précurseurs chimiques, solides, liquides ou gazeux, qui réagissent en phase gazeuse avec les grains réduits issus de la première étape.

Un tel traitement permet d'obtenir des couches homogènes d'un corps localisées au niveau de la surface des grains réduits, et en l'absence de toute diffusion du corps dans les pores formés dans l'épaisseur des grains.

Ce procédé de revêtement par voie chimique en phase gazeuse constitue une alternative au revêtement métallique en couche mince de l'art antérieur.

Il permet d'obturer les pores des grains réduits lors de la première étape, et de proposer des particules métalliques revêtues utilisables dans des application qui ne tolèreraient pas de structure poreuse à pores ouverts.

Pendant la fluidisation des grains dans le réacteur de traitement 1, la vapeur d'un ou plusieurs précurseurs chimiques est introduite par la partie inférieure du réacteur 1 sous température constante et sous un flux de gaz porteur, à partir du module de production et gestion des précurseurs 40.

La production de la vapeur dépend de la nature du précurseur qui peut être gazeux, liquide ou solide. La vapeur est formée dans les récipients 41, 42 ou 43.

La décomposition de la vapeur et le dépôt d'un corps sur les grains réduits a lieu dans le réacteur de traitement 1.

La description qui va suivre concerne la réalisation d'un revêtement à base chrome, obtenu à partir d'un précurseur organométallique solide. Pour ce faire, on peut notamment utiliser de l'acétylacétonate de chrome, du cycloheptatriènetricarbonyle de chrome ou du dicumène de chrome.

Pour éviter l'obtention de fines particules de chrome dans le réacteur de traitement 1 en plus des particules métalliques revêtues, le précurseur organométallique a été vaporisé avant son introduction dans le réacteur 1.

La transformation du solide en vapeur a lieu dans le récipient 43, qui est un lit fluidisé chauffé par résistances électriques 45. La température de vaporisation est inférieure à 250 °C. Le transport de la vapeur vers le réacteur de traitement 1 est effectué principalement sous un gaz inerte, par exemple sous azote. Le trajet est isolé thermiquement au moyen de moyens connus classiques 46.

La vapeur d'organométallique est envoyée vers la partie inférieure du réacteur de traitement 1 dans lequel les grains réduits lors de la première étape sont maintenus en fluidisation par de l'azote à une température de 400 à 500°C, sous un chauffage par induction 3. La durée du traitement est de 2 à 4 heures. On obtient ainsi une couche uniforme de chrome en surface des grains.

D'autres revêtement métalliques peuvent être envisagés. A titre d'illustrations, on peut citer le cobalt obtenu à partir d'un précurseur liquide, le nitrosyltricarbonyle de cobalt, ou à partir d'un précurseur solide, l'acétylacétonate de cobalt ; un revêtement d'aluminium peut être obtenu à partir de triéthylaluminium.

Le choix du revêtement n'est pas limité aux exemples précités.

Une mesure de surface spécifique indique qu'à ce stade du processus, les pores ouverts des grains réduits issus de la première étape ont été pratiquement recouverts.

Les réactions chimiques en phase gazeuse par l'utilisation de précurseurs organométalliques, forment donc sur les grains, des couches homogènes de métal, oxyde, carbure, nitrure, borure et mélanges, sans ou avec une très faible zone de diffusion.

Pour améliorer l'accrochage de ces revêtements à la surface des particules, un traitement d'activation de la surface par plasma peut être réalisé, préalablement au procédé de revêtement par voie chimique en phase gazeuse.

### 2^{ème} type de dépôt

On peut réaliser la diffusion d'au moins un corps, tel qu'un métalloïde ou un métal, dans les grains réduits obtenus lors la première étape, par dissociation ou réduction de gaz actifs comme l'ammoniac, le méthane, le trichlorure de bore, l'oxygène,... ou de solides actifs.

Grâce à ce second mode de réalisation, on obtient des particules composites dans lesquelles le ou les corps déposés lors de la seconde étape ont diffusé, à travers les pores formés lors de la première étape, dans l'épaisseur des grains, dans la structure cristalline métallique, la porosité issue de la première étape de réduction pouvant être conservée, éventuellement partiellement, ou non.

Le réacteur de traitement 1 est réglé à une température comprise entre 560 et 700 °C. Le refroidissement du réacteur 1 et de son contenu à une telle température est assuré par arrêt du réacteur de traitement 1 et du four électrique 21.

La fluidisation des grains est réalisé par un gaz porteur, qui peut éventuellement être préchauffé. Dans le cas présent, les grains de fer métallique poreux sont fluidisés avec de l'azote.

Les gaz actifs sont dissociés ou non dans le four électrique 21. Le gaz porteur initial, dans le cas présent l'azote pur, agissant comme agent de fluidisation, est remplacé par un mélange formé par 60% d'azote, 30% d'ammoniac et de 10% de méthane (CH₄).

La pression des gaz et leur débit sont bien évidemment réglés en fonction de la taille et la nature des grains réduits à traiter.

Le temps de traitement à la température fixée est inférieur à 8 heures.

Le taux de dissociation de l'ammoniac est déterminé à l'aide du dissociomètre 61. Ce taux est supérieur à 80% en début de traitement et descend à 15 % vers la fin du cycle.

Le contrôle de la dissociation du méthane en carbone et donc de la teneur en carbone est réalisé par une mesure du point de rosée.

Les atomes de carbone et d'azote diffusent dans les grains de fer poreux suivant les chemins des pores jusqu'à coeur.

La morphologie d'un grain de poudre de fer poreux après ce traitement est la suivante : en surface mais aussi aux alentours de chaque pore, on observe une couche blanche de carbonitrures ε(Fe₂₋₃CN), suivie plus en profondeur par une couche de diffusion. La couche obtenue en surface des grains par le traitement mettant en oeuvre le mélange formé par azote, ammoniac et méthane est moins fragile que celle obtenue avec un traitement de diffusion uniquement à base d'azote. Cette augmentation de la dureté des grains est notamment due à la présence du carbone.

D'autres mélanges des gaz de traitement sont envisageables. On peut notamment citer :
- N₂ (49%) + NH₃ (50%) + CO₂ (1%)
- NH₃ (14%) + gaz endothermique (86%)
- air (30%) + NH₃ (40%) + gaz naturel ou CH₄ (30%)

Un premier cas particulier de ce traitement constitue la diffusion d'azote et de carbone à l'état ferritique. Dans ce cas la température de traitement est fixée à 570°C et la durée du traitement est inférieure à 5 heures. Le mélange des gaz de traitement est formé de N₂ (47%) + NH₃ (50%) + gaz naturel ou CH₄ (3%).

Le résultat de ce traitement est une monocouche ε (maximum 9% d'azote massique) sur une sous-couche de diffusion, ce qui conduit à une augmentation de la dureté, à une diminution de la fragilité et à de bonnes propriétés de frottement des particules métalliques revêtues.

Un deuxième cas particulier constitue la diffusion d'azote et de carbone à l'état austénitique. Le traitement a lieu à 700°C et la durée de traitement est d'environ 2 heures. Le mélange des gaz de traitement est formé par exemple de N₂ (48%) + NH₃ (50%) + gaz naturel ou CH₄ (2%), ou de N₂ (65%) + NH₃ (30%) + CO₂ (5%).

L'existence d'une structure poreuse des grains facilite la diffusion plus ou moins à coeur d'un ou plusieurs corps, comme par exemple un non-métal tel que le carbone, l'azote, un métal tel que l'aluminium, le chrome, le titane, le vanadium, le silicium, ou un métalloïde tel que le bore ou le soufre. Ainsi, il est possible de réduire d'une manière très importante le temps de cette étape de dépôt par rapport aux traitements de l'art antérieur.

Le choix du métal, du non-métal ou du métalloïde à diffuser n'est pas limité aux exemples précités.

### 3^{ème} type de dépôt

Le troisième type de dépôt qui va être décrit ci-après permet d'obtenir, à la surface des grains réduits issus de la première étape, une structure non homogène de type dendritique, avec des axes de croissance privilégiée d'un composé métallique ou non.

Pour empêcher la formation d'une couche continue et homogène, et en même temps pouvoir contrôler l'accrochage des germes d'un composé sur les grains, un traitement spécifique de leur surface est nécessaire.

Il consiste à rendre la surface des grains hydrophobe, par un dépôt de silice par exemple, puis d'y créer des centres de germination par une activation au palladium.

Afin d'augmenter son caractère hydrophobe, les grains sont traités par un plasma d'azote, par exemple en post-décharge lointaine, grâce au module de production et gestion du plasma à post-décharge lointaine et du vide 50. Ce pré-traitement est réalisé durant 25 minutes avec un débit d'azote de 500 cm³/min et une puissance micro-onde de 500 W. L'augmentation du caractère hydrophobe est contrôlée à partir de la masse d'eau absorbée par une colonne de poudre mise en contact avec ce liquide.

Bien évidemment, l'utilisation du module de production et gestion du plasma à post-décharge lointaine et du vide 50 a lieu à la température ambiante. Le réacteur de traitement 1, précédemment chauffé par induction à 100°C, est refroidi par l'arrêt du chauffage des grains et par le maintien de la fluidisation à l'azote. Un vide primaire est ensuite réalisé. Au fur et à mesure de la réalisation du vide de plus en plus poussé, le débit de l'azote de fluidisation diminue.

La décomposition d'un précurseur silicé est d'autant plus importante qu'on y ajoute un faible pourcentage d'oxygène. Le dépôt est effectué avec le tétraméthyldisiloxane (TMDS) vaporisé, entraîné par l'oxygène et incorporé au gaz plasmagène.

L'activation locale de la surface des grains afin de créer des centres de germination localisés d'un composé métallique, est possible dans un bain acide de palladium à 0.1%, par la réalisation d'un lit fluidisé trois phases.

La fluidisation des grains solides dans le liquide a lieu à l'azote.

Le bain d'activation est préparé dans le bac de préparation 31 et puis introduit dans le réacteur de traitement 1, chauffé ou non. Le traitement des poudres dure environ 30 minutes à la température ambiante. En fin de traitement, le liquide est évacué à l'aide de la pompe 34 dans le bac de stockage 32. Les grains peuvent alors être envoyés dans le réservoir 11 puis séchés.

Après traitement, on retrouve en surface des grains de fines particules de palladium qui constitueront les futurs centres de cristallisation du revêtement ultérieur.

Il reste également possible de réaliser une dernière opération de revêtement des grains revêtus de palladium afin d'obtenir la germination et la croissance non homogène d'un composé, qui peut être ou non métallique, sur les centres de germination formés précédemment.

Le seul moyen technique pour revêtir d'une manière anisotrope des grains solides est le revêtement en lit fluidisé trois phases. On peut en particulier réaliser des revêtements présentant une forte anisotropie.

Les réactions de germination, croissance et coalescence des germes d'un composé intermétallique ou phase intermédiaire ont lieu dans un milieu liquide à la surface des grains solides à traiter en suspension. On envisage un dépôt de métal de type nickel, cuivre, argent, cobalt, platine,...

La phase gazeuse est formée par le gaz porteur qui a le rôle d'agent de fluidisation et est, en l'espèce, l'azote. La phase liquide est formée par un mélange de produits dont le sel du métal à déposer et un agent réducteur. La phase solide est représentée par les grains réduits et portant les centres de cristallisation.

Pour une germination et croissance de l'argent, on utilise un mélange liquide actif constitué par exemple d'un sel d'argent, d'un complexant aminé, d'un réducteur et d'un stabilisant. Le traitement a lieu sans chauffage et pendant 4 heures. On obtient une couche d'argent qui enrobe partiellement les grains. L'épaisseur de la couche est non homogène. La teneur en argent est inférieure à 15% massique. L'utilisation de la fluidisation à l'azote assure une structure identique de tous les grains.

Pour un revêtement hétérogène de nickel, le mélange des liquides actifs est formé d'un sel de nickel (acétate, sulfate ou hydroxyde), d'un complexant aminé, d'un réducteur et de soude. La température de traitement est de 80 °C, pendant 5 heures. On obtient une couche à 5% massique de nickel.

Pour un revêtement hétérogène de cuivre, le mélange des liquides actifs est formé de sulfate de cuivre, d'un complexe aminé, d'un réducteur et de soude. La température de traitement est de 50 °C, pendant 5 heures. On obtient un revêtement à 10% massique de cuivre.

Le traitement terminé, la phase liquide est évacuée du réacteur de traitement 1 et les particules métalliques revêtues ainsi obtenues sont séchées sous un courant d'azote. Le chauffage par résistances électriques du réacteur de traitement 1 est activé. La température est fixé à 200 °C. Elle peut être plus élevée si un traitement thermique final de recuit est nécessaire.

Le choix du revêtement n'est pas limité aux exemples ci-dessus.

Après traitement, les particules composites sont refroidies sous azote et évacuées dans le bac récupérateur étanche 11.

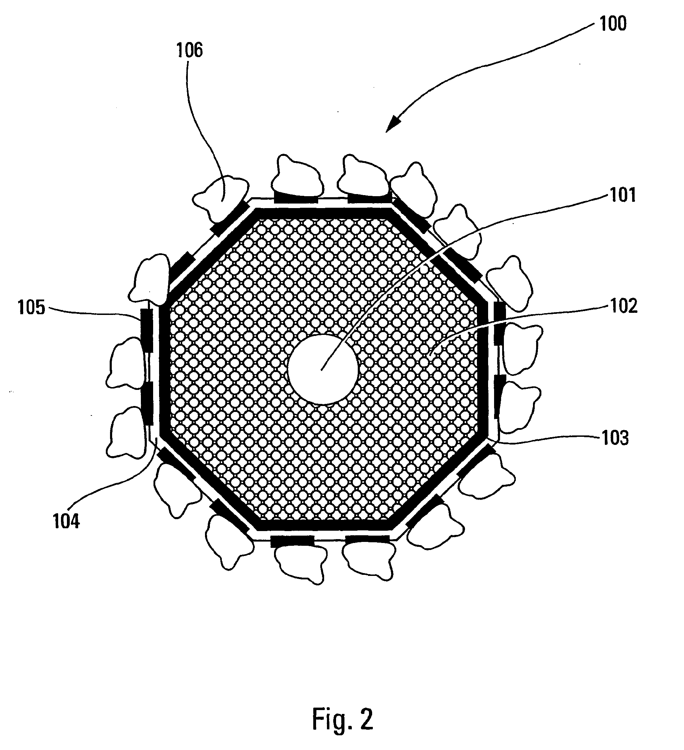

La réalisation de l'un ou plusieurs des types de traitement évoqués ci-dessus permet une modification à la fois volumique et/ou surfacique de la composition chimique et/ou morphologique des grains. On peut ainsi obtenir une particule métallique revêtue ayant par exemple une structure telle que représentée à la figure 2.

Sur la figure 2, la particule métallique revêtue 100 comporte en son centre un coeur d'oxyde non transformé 101 entouré d'une zone poreuse réduite 102, le coeur et la zone poreuse ayant été formée lors d'une première étape de réduction partielle d'un grain d'oxyde métallique.

La zone poreuse réduite 102 peut être traitée par le deuxième type de dépôt pour la réalisation d'une diffusion d'un métal ou d'un métalloïde dans la zone poreuse réduite 102.

Cette zone poreuse réduite 102 peut ensuite être revêtue d'une couche d'obturation des pores ouverts 103, formée par dépôt du 1^{er} type.

Par un traitement tel que celui décrit pour le 3^{ème} type de dépôt, la couche d'obturation des pores ouverts 103 peut être revêtue d'une couche hydrophobe 104, sur laquelle sont ensuite créés des centres de germination localisés 105 d'un composé métallique.

A partir de ces centres de germination localisés 105, on réalise des germinations et croissance d'un composé 106.

Des procédés connus de métallurgie des poudres, tels que frittage, agglomération, compression isostatique à froid ou à chaud, injection,... permettent de réaliser des matériaux composites de forme quelconque à partir des particules métalliques revêtues obtenues.

On pourra ainsi assembler les particules métalliques revêtues pour former un ensemble, cet ensemble étant par exemple soumis à une étape de mise en forme et/ou une étape de consolidation.

L'étape de mise en forme est par exemple choisie parmi le compactage, le moulage, l'injection.

L'étape de consolidation est par exemple choisie parmi le frittage, le compactage isostatique à chaud, l'agglomération.

Les particules métalliques revêtues réalisées selon le procédé de fabrication de la présente invention peuvent avoir de très nombreuses utilisations.

Projetées par un procédé thermique ou électrostatique ou encore déposées sous forme de peinture, les particules métalliques revêtues selon l'invention peuvent permettre de réaliser des revêtements sur la surface d'un support, par exemple en métal, en verre ou en céramique, et ainsi former des couches composites conférant des propriétés spécifiques au support revêtu telles que isolation ou conductivité électrique, thermique, magnétique ou électromagnétique, mais encore conférer un effet décoratif.

A partir de ces particules métalliques revêtues selon l'invention, on peut également fabriquer des matériaux composites du type céramiques techniques à haute performance et dotées de fonctionnalités particulières. On peut notamment les employer pour la fabrication d'outils de coupe à base de WC/Co, de matériaux magnétiques à base de ferrites, de piles à combustibles.

Les matériaux composites obtenus procédé de la présente invention peuvent également être employés dans des applications alimentaires, sous forme de moules élastiques ou rigides, notamment.

Dans le cas particulier de la mise en oeuvre du deuxième type de dépôt décrit ci-dessus mettant en oeuvre la diffusion d'au moins un corps dans les grains réduits, on peut fabriquer des matériaux composites, tels que des moules, matrices et biomatériaux pour des implants osseux, présentant une porosité contrôlée homogène ou hétérogène et des propriétés mécaniques spécifiques.

## Revendications

1. Procédé de fabrication de particules métalliques revêtues à partir de grains d'un oxyde ou d'un mélange d'oxydes d'au moins un métal, dans lequel on réalise :
- une première étape de réduction au moins partielle des grains de l'oxyde métallique au moyen d'un gaz réducteur en lit fluidisé à une température prédéterminée, et
- une seconde étape de dépôt, dans un lit fluidisé, d'un ou plusieurs corps choisis parmi les métaux, les non-métaux, les métalloïdes, les céramiques,
**caractérisé en ce que**, lors de la première étape, on chauffe les grains au moyen d'un chauffage par induction, les grains étant, dans l'hypothèse où ils ne seraient pas magnétiques, préalablement chauffés indirectement par résistances électriques, le chauffage par induction étant effectué à une fréquence prédéterminée choisie de façon à régler ou à limiter la zone de pénétration des courants induits à l'intérieur des grains.

2. Procédé selon la revendication 1, **caractérisé en ce que**, lors de la seconde étape de dépôt, on chauffe les grains au moyen d'un chauffage par induction à une fréquence prédéterminée choisie de façon à limiter les réactions chimiques au volume chauffé des grains.

3. Procédé selon la revendication 1 ou 2, **caractérisé en ce que**, lors de la seconde étape de dépôt, on utilise des précurseurs qui réagissent en phase gazeuse avec les grains réduits obtenus lors de la première étape.

4. Procédé selon la revendication 3, **caractérisé en ce que** l'on utilise des précurseurs solides tels que des composés organométalliques ou métallo-organiques.

5. Procédé selon la revendication 3 ou 4, **caractérisé en ce que** l'étape de dépôt est précédée par une étape d'activation de la surface des grains, au moyen d'un plasma, par exemple un plasma d'azote en post-décharge non ionique lointaine.

6. Procédé selon l'une quelconque des revendications 1 à 5, **caractérisé en ce que**, lors de la seconde étape de dépôt, on réalise la diffusion d'au moins un corps dans les grains réduits obtenus lors la première étape, par dissociation ou décomposition de gaz actifs ou de solides actifs.

7. Procédé selon l'une quelconque des revendications 1 à 6, **caractérisé en ce que**, lors de la seconde étape de dépôt, on réalise un lit fluidisé triphasique comprenant une phase solide formée par les grains réduits obtenus lors de la première étape, une phase gazeuse comprenant un gaz de fluidisation inerte et une phase liquide comprenant un mélange de sels métalliques et un réducteur.

8. Procédé selon l'une quelconque des revendications 1 à 7, **caractérisé en ce que** le gaz réducteur de la première étape est généré in situ à partir, par exemple, du méthane ou de l'ammoniac.

9. Procédé selon l'une quelconque des revendications 1 à 8, **caractérisé en ce que** l'on utilise des grains d'oxydes naturels ou de mélange d'oxydes naturels.

10. Procédé selon la revendication 9, **caractérisé en ce que** les grains sont des grains d'oxydes de fer, notamment des grains d'un minerai de fer riche.

11. Procédé de fabrication d'un matériau composite à partir de particules métalliques revêtues obtenues par le procédé selon l'une quelconque des revendications 1 à 10, **caractérisé en ce que** les particules métalliques revêtues sont assemblées pour former un ensemble, cet ensemble étant par exemple soumis à une étape de mise en forme et/ou une étape de consolidation, l'étape de mise en forme étant par exemple choisie parmi le compactage, le moulage, l'injection, et l'étape de consolidation étant par exemple choisie parmi le frittage, le compactage isostatique à chaud, l'agglomération.
